# EUROPEAN PATENT SPECIFICATION

(11) **EP 2 264 883 B1**
(45) Date of publication and mention of the grant of the patent: **08.01.2020**
(21) Application number: 10251053.4
(22) Date of filing: 08.06.2010
(51) Int. Cl.: H02M 7/00, H05K 5/02

(54) **Power converter for railway rolling stock**
Stromrichter für ein Schienenfahrzeug
Convertisseur de puissance pour véhicule sur rails

(30) Priority: 08.06.2009 JP 2009136808
(43) Date of publication of application: 22.12.2010
(73) Proprietor: Hitachi, Ltd., Chiyoda-ku Tokyo 100-8280 (JP)
(72) Inventor: Yamaguchi, Satoshi, Tokyo 100-8280 (JP); Hishida, Akihiro, Tokyo 100-8280 (JP); Tanaka, Takeshi, Tokyo 100-8280 (JP); Kono, Yasuhiko, Tokyo 100-8280 (JP); Nakata, Kiyoshi, Tokyo 100-8280 (JP)
(74) Representative: Mewburn Ellis LLP

(56) References cited:
- EP-A1- 1 843 455
- EP-A2- 2 006 987
- EP-A2- 2 023 473
- JP-A- 2003 235 112
- JP-A- 2006 254 656
- US-A1- 2003 132 041
- "BORDLINE® designed for LRV", , 2008, XP055149659, Retrieved from the Internet: URL:http://www05.abb.com/global/scot/scot2 32.nsf/veritydisplay/a698c8f0183bafa7c1257 5eb003fc042/$file/abb_traction-converters_ lrv_v3f_web.pdf [retrieved on 2014-10-29] & "ABB Traction converters BORDLINE®", , 2008, Retrieved from the Internet: URL:http://www.abb.de/tractionconverters [retrieved on 2014-10-29]
- FANG Z PENG ET AL: "Development of a 1.5 MVA Universal Converter Module for Traction Drive and Utility Applications", POWER ELECTRONICS SPECIALISTS CONFERENCE, 2005. PESC '05. IEEE 36TH, IEEE, PISCATAWAY, NJ, USA, 1 January 2005 (2005-01-01), pages 2290-2295, XP031000452, DOI: 10.1109/PESC.2005.1581951 ISBN: 978-0-7803-9033-1

## Description

### TECHNICAL FIELD

The present invention relates to a traction circuit mounting structure of a power converter in general, and more specifically, relates to a traction circuit mounting structure of a power converter for a railway rolling stock.

### BACKGROUND ART

A power converter disposed on a railway rolling stock is a device for converting the power entered from a railway overhead contact line via the switching operation of a traction circuit composed of a plurality of insulated gate type bipolar transistors (IGBT), so as to control a motor of the railway rolling stock. A traction circuit, which is the main component of the power converter, is composed for example of IGBTs as switching devices, driver circuits thereof, a cooling unit for the IGBTs, and a filter capacitor for stabilizing the DC power entered from the overhead contact line.

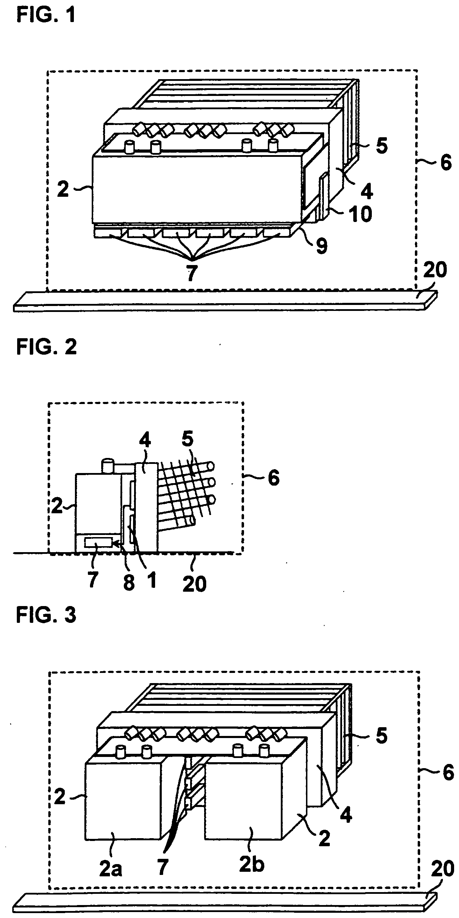

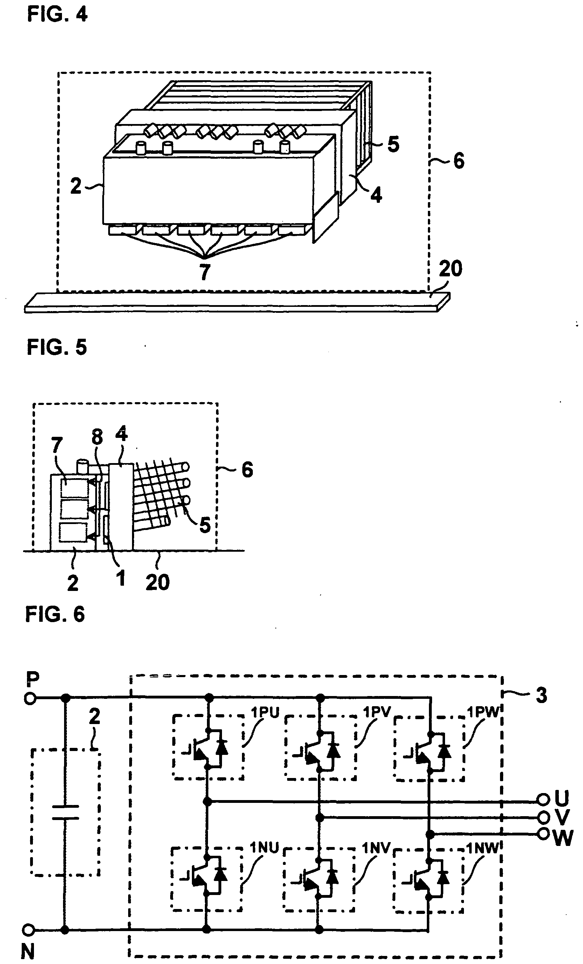

FIG. 3 shows a perspective view of a prior art power converter, and FIG. 5 is a side view of the prior art power converter.

The arrangement of the power converter will be described with reference to FIGS. 3 and 5. IGBTs 1 are attached within a box 20 to a cooling block 4 of a semiconductor cooling unit including a cooling block 4 and a cooling fin 5, by which the heat losses are radiated to the atmosphere outside the device. The semiconductor cooling unit, IGBTs 1 corresponding to three phases of U, V and W and a filter capacitor 2 are stored within a single box 20, thereby constituting a power converter unit 6.

Gate signals to the IGBTs 1 are output from gate control circuits 7 and transmitted via gate wires 8 to the respective IGBTs 1. The filter capacitor 2 are separated into two parts and arranged in a separated manner on left and right sides of FIG. 3. The gate control circuit 7 is arranged in a space at the center of the filter capacitor 2 divided into two parts. Here, the integral components including the IGBTs 1, the gate control circuits 7, the gate wires 8, the cooling unit, the conductor bar and a frame for supporting and connecting these components are specifically called a power unit.

The power converter unit 6 having the structure shown in FIGS. 3 and 5 adopts a structure in which the filter capacitor 2 are divided into two parts and arranged on right and left sides of the unit, the thickness of the filter capacitor 2 in the front-rear direction of FIG. 3 is increased compared to a filter capacitor that.is not divided into two parts. As a result, the gate control circuits 7 are arranged at a relatively deep position within the frame arrangement, and therefore, maintenance operations requiring visual confirmation of the gate control circuits 7 and circuit checks thereof become difficult. Especially, since the distance between the divided filter capacitors 2 defining a maintenance space for the gate control circuits 7 is narrow, there was a drawback in that the connecting and disconnecting operation of optical fibers and the like was difficult. Furthermore, since the gate control circuits corresponding to three phases are arranged collectively at the center, the gate wires 8 within the power converter unit 6 must also be collectively arranged at the center, so that it was difficult to ensure sufficient space for wiring. In further detail, separating and binding of wires considering the influence of noise could not be performed sufficiently due to space limitation, and measures against noise could not be taken sufficiently. Furthermore, the gate control circuits 7 were arranged at the center where heat tended to gather, and especially, the gate control circuits arranged at the upper area were heated by the heat generated from the lower gate control circuits, by which the circuits were exposed to thermally hostile environment.

Furthermore, since the filter capacitor is divided into two parts, 2a and 2b, according to the arrangement illustrated in FIGS. 3 and 5, the number of components related to the wire conductors and support members connected to the filter capacitor 2 was increased, causing complication of the arrangement of the device or increase of weight thereof.

One arrangement for solving such problems mentioned above is disclosed for example in Japanese patent laid-open publication No. 2003-23778 (patent document 1). The brochures "BORDLINE ® designed for LRV" and "ABB Traction Converters BORDLINE ®" both published by ABB in 2008 disclose a highly integrated modular power converter to be mounted in a common housing under-floor at a train carriage.

The patent application EP 2 006 987 discloses another example of a highly integrated modular inverter in a common housing.

The document "Development of a 1.5 MVA Universal Converter Module for Ship Propulsion, Traction Drive and Utility Applications", published by Peng, Wang at the Power Electronics Specialist Conference 2005, describes a further example of such a highly integrated converter module.

The arrangement disclosed in patent document 1 will be described with reference to FIG. 4.

According to the arrangement illustrated in FIG. 4, similar to the arrangement described above, IGBTs 1 are attached within a box 20 to a cooling block 4 of a semiconductor cooling unit including a cooling block 4 and a cooling fin 5, thereby radiating the heat losses to the atmospheric air outside the device. A power converter unit 6 is composed by storing the semiconductor cooling unit including the cooling block 4 and the cooling fin 5, a filter capacitor 2 and IGBTs 1 corresponding to three phases of U, V and W in a single box 20.

Since the gate control circuits 7 are arranged side by side on a lower side of the filter capacitor 2, the gate control circuits can be accessed easily. Further, the filter capacitor is arranged above the gate control circuits as a single component without being divided.

However, the above-mentioned arrangement has the following drawbacks.

According to the power converter shown in FIG. 4, the filter capacitor 2 and the aforementioned power unit are arranged in a divided manner, wherein the filter capacitor 2 is fixed and supported on the box 20 before the wires of the power unit and the filter capacitor 2 are connected, so that the filter capacitor 2 and the power unit are independently fixed on the box 20.

Now, if the power converter must be removed from the box for maintenance operation of the power converter during commercial operation of the power converter mounted on a railway rolling stock, it is necessary to remove the fixing support members between the filter capacitor and the box, disconnect wires between the filter capacitor and the unit, remove the filter capacitor from the box, remove the fixing support members between the unit and the box, and detach the unit from the box. Since the box must be arranged within a limited space under the floor of the railway vehicle, the size of the box is small, and the operation for disconnecting wires between the filter capacitor and the unit within the small box is not only very difficult but also time-consuming for operators. Further, there are a large number of steps required for removing the power converter from the box, and the operation thereof is complex.

Furthermore, since the filter capacitor and the unit are independently supported and fixed on the box, a large number of components such as the fixing support members is necessary, and the weight of the whole device is increased.

In consideration of the drawbacks of the prior art power converter, the present invention aims at providing a power converter capable of improving the maintenance performance and downsizing the power converter.

### SUMMARY OF THE INVENTION

In order to achieve the above-mentioned object, the present invention provides a power converter according to claim 1.

The present power converter can further adopt an arrangement in which a plurality of gate control circuits are fixed to a unit frame, so as to enable the circuits to be attached to and detached from the device collectively. By adopting such structure, the access property and maintenance performance of the power converter can be improved.

Furthermore, for integrating the filter capacitor, it is possible to adopt a self-standing frame 10 for stabilizing the power converter unit. By adopting this arrangement, it becomes possible to improve the maintenance performance and the workability of the power converter unit.

According to the present invention, it becomes possible to provide a power converter for a railway rolling stock capable of improving the maintenance performance and reducing the costs of the converter.

### BRIEF DESCRIPTION OF THE DRAWINGS

FIG. 1 is a perspective view showing one preferred embodiment of the present invention;
FIG. 2 is a side view showing one preferred embodiment of the present invention;
FIG. 3 is a first perspective view of a prior art embodiment;
FIG. 4 is a second perspective view of a prior art embodiment;
FIG. 5 is a side view showing a prior art embodiment; and
FIG. 6 is an electric circuit diagram showing a power converter according to one preferred embodiment of the present invention.

### BEST MODE FOR CARRYING OUT THE INVENTION

FIG. 1 is a perspective view of a power converter according to one preferred embodiment of the present invention, and FIG. 2 is a side view of the power converter.

As illustrated in FIGS. 1 and 2, the power converter according to the present embodiment comprises a power converter unit 6 corresponding collectively to three phases of U, V and W and having insulated gate type bipolar transistors (IGBTs) 1, a filter capacitor 2, a cooling block 4, a cooling fin 5 and gate control circuits 7, wherein the power converter unit 6 is stored in a fixed manner in the interior of a box 20. In the box 20, the IGBTs 1 are attached to the cooling block 4 of a semiconductor cooling unit including the cooling block 4 and the cooling fin 5, and the heat loss generated from the IGBTs 1 are radiated to the atmospheric air outside the power converter.

The gate signals to the IGBTs 1 are output from the gate control circuits 7 and transmitted via gate wires 8 to the respective IGBTs 1. The gate control circuits 7 are disposed on the lower side of the power converter unit 6 within the space below the bottom side of the filter capacitor 2 and on the front side of FIG. 1 (on the opposite side from the cooling fin). Moreover, the gate control circuits 7 have connecting terminals for optical fibers functioning as input ends for receiving input of signals from the exterior arranged toward the front side of FIG. 1 (not shown).

The filter capacitor 2 is fixed to and constitutes an integral structure with the semiconductor cooling unit, the IGBTs 1 and the gate control circuits 7. The gate wires 8 extending from the gate control circuits 7 arranged on the lower side of the power converter unit 6 to the IGBTs 1 are arranged so that the respective phases have equivalent lengths.

Next, the traction circuit arrangement of the power converter according to the present embodiment will be described with reference to FIG. 6. FIG. 6 is a circuit connecting diagram illustrating the traction circuit arrangement of the power converter. The feeding system of railways is either an AC system or a DC system, and the traction motor can be either an AC motor or a DC motor. Therefore, based on the combination of the feeding system and the motor, the power converter can adopt an inverter alone, a converter alone, or a combination of an inverter and a converter, wherein according to the present embodiment, we will described as an example an inverter applied to a combination of a DC feeding system and an AC motor.

The traction circuit according to the present embodiment is composed of a filter capacitor 2 connected between DC terminals P and N, and a three-phase inverter 3. The three-phase inverter 3 is a device for converting the input DC to a three-phase AC having an arbitrary frequency and an arbitrary voltage, and outputting the three-phase AC to AC terminals U, V and W. Six semiconductor devices (PU, NU, PV, NV, PW, NW) of the three-phase inverter 3 are composed of IGBTs 1. The IGBT 1 corresponding to the respective phase is composed of a free-wheel diode connected in parallel to one device and another device. According to the structural example illustrated in the present specification, the respective semiconductor devices (PU, NU, PV, NV, PW, NW) are referred to collectively as IGBTs 1.

According to the characteristic feature of the present embodiment, since the filter capacitor and the power unit are integrated as mentioned earlier, it can be attached to and removed from the box as an integral device, so that the connecting of wires within the power converter unit does not have to be performed within the box, and the connecting of wires within the power converter unit can be performed after taking out the power converter unit from the box. In other words, the troublesome operation within the small box can be saved, and the maintenance performance of the device can be improved. Moreover, since the filter capacitor 2 and the power unit are fixed to and supported in the box as an integral structure, they can be attached to and detached from the box as an integral device so that the number of components required to fix and support the box and the power converter unit can be reduced, the number of steps for attaching and detaching the unit from the box can be reduced, the weight of the arrangement can be reduced and the arrangement can be simplified. Moreover, since the gate control circuits 7 are arranged within the space below the lower side of the filter capacitor 2, the gate wires 8 can be arranged with equivalent lengths with respect to the IGBTs 1 of the respective phases, and the gate wires 8 can be arranged in an orderly manner in bundles without being arranged in disorder around the gate control circuits 7. Therefore, the wires can be bundled together considering measures against noise, and erroneous operations caused by noise can be prevented.

According further to the present embodiment, the gate control circuits 7 are arranged close to the front side of the power converter unit 6 (on the opposite side from the cooling fin), so that during maintenance of the power converter, maintenance can be performed by accessing the various devices within the power converter unit from the front side of FIG. 1, improving the workability of attaching and detaching the devices of the gate control circuits 7 or the optical fiber connectors, and improving the workability related to checking the gate control circuits 7. Moreover, since the gate control circuits 7 are arranged side by side in a horizontal alignment instead of being stacked one above the other in a vertical arrangement, the heat generated from the gate control circuits 7 will not affect other gate control circuits 7.

According further to the present embodiment, since the power converter unit including the filter capacitor 2, the semiconductor cooling unit, the IGBTs 1 and the gate control circuits 7 formed in an integral manner is fixed to the box as an integral structure, the power converter unit can be attached to and detached from the box as an integral device, so that the number of components for fixing and supporting the power converter unit on the box can be reduced, the number of steps required for attaching and detaching the unit on the box can be reduced, and the costs related to the power converter can be cut down.

Further, since the power converter unit can be easily attached to and detached from the box as an integral device, it is not necessary to connect wires within the power converter unit inside the box, and wires within the power converter unit can be connected after removing the power converter unit from the box. In other words, it is not necessary to perform complex operations within the small box, and the maintenance performance of the power converter can be improved.

The prior art power converter illustrated in FIG. 4 has a unit including the semiconductor devices and a filter capacitor independently fixed to the box 20, wherein the filter capacitor and the unit are connected via wires within the box. Therefore, considering the wiring operation, there was a restriction to the reduction of the distance between the filter capacitor and the unit on the circuit. On the other hand, according to the present embodiment, the filter capacitor and the unit including the inverter are fixed in an integral manner, so that there is no need to perform wiring operation within the box. Therefore, the distance between the filter capacitor and the semiconductor devices on the circuit can be minimized compared to the prior art power converter, and thus, the inductance of the power converter can be reduced.

According to the prior art arrangement, there was no consideration related to facilitating the attaching and detaching operation of the gate control circuits, and in order to detach the gate circuits from the semiconductor cooling unit, it was necessary to detach the wires and the fixing members between the respective gate control circuits and the semiconductor cooling unit, which deteriorated the maintenance performance of the power converter. However, according to the present embodiment, the gate control circuits 7 are disposed on the front side on the lower side of the power converter unit 6 together with the unit frame 9. The unit frame 9 can be removed in an integral manner from the semiconductor cooling unit. By adopting this arrangement, the performance of the attaching and detaching operations of the gate control circuits can be improved, and the workability during the checking operation of the gate control circuits can be improved. Further, by adopting a slot-in arrangement for the wiring between the gate control circuits 7 and the semiconductor cooling unit according to which the wiring can be connected by pushing the unit frame 9 into a fixing position with respect to the semiconductor cooling unit, the maintenance performance of the power converter can further be improved.

According to the present embodiment, it is possible to additionally dispose a self-standing frame 10 on the lower portion of the power converter unit 6. By arranging the self-standing frame 10 on the lower portion of the power converter unit 6, the power converter unit 6 can be arranged in a self-standing manner before being fixed to the box, so that the mounting operation for attaching the unit to the box can be facilitated. Further, the handling of the power converter unit during maintenance operation can be facilitated.

## Claims

1. A power converter for a railway rolling stock comprising:
a plurality of semiconductor devices (1) constituting a power converter circuit;
a plurality of gate control circuits (7) for supplying gate signals to the semiconductor devices;
a filter capacitor (2) connected to DC terminals of the power converter circuit for smoothing a DC current;
a cooling block (4) attached to the semiconductor devices; and
a cooling fin (5) for radiating heat generated by the semiconductor devices to the atmosphere;
wherein:
the semiconductor devices, the filter capacitor, the cooling block, the cooling fin and the gate control circuits are comprised in a power converter unit (6) which is stored within a common box (20) mounted below a floor of the railway rolling stock;
**characterized in that**:
the filter capacitor, the semiconductor devices, the cooling block, the cooling fin and the gate control circuits are fixed to each other and fixed and supported to the common box, so that the power converter unit can be attached to and detached from the common box as an integral device;
the plurality of gate control circuits are arranged in a space at a front side of the power converter unit and below the filter capacitor;
the cooling fin is arranged on the back side of the power converter unit;
the plurality of gate control circuits are fixed to a common frame (9) so that the gate control circuits can be attached and detached in a collective manner;
wiring between the plurality of gate control circuits and the cooling block adopts a slot-in arrangement, so that the wiring is connected by pushing the common frame into a fixing position with respect to the cooling block; and
the plurality of gate control circuits have connecting terminals for receiving input of signals from the exterior at the front side of the gate control circuits.

2. The power converter for a railway rolling stock according to claim 1, further comprising:
a self-standing frame (10) arranged on the lower portion of the power converter unit for enabling the power converter to stand independently from the common box before being fixed to the common box.

3. The power converter for a railway rolling stock according to claim 1, wherein
the plurality of gate control circuits are arranged side by side in a horizontal arrangement.

## Patentansprüche

1. Stromrichter für ein Schienenfahrzeug, der Folgendes umfasst:
eine Vielzahl von Halbleitervorrichtungen (1), die eine Stromrichterschaltung bilden;
eine Vielzahl von Gate-Steuerschaltungen (7) zur Bereitstellung von Gate-Signalen für die Halbleitervorrichtungen;
einen Filterkondensator (2), der mit Gleichstromanschlüssen der Stromrichterschaltung verbunden ist, um einen Gleichstrom zu glätten;
einen Kühlblock (4), der an den Halbleitervorrichtungen angebracht ist; und
eine Kühlrippe (5) zum Abstrahlen der durch die Halbleitervorrichtungen erzeugten Wärme in die Atmosphäre;
wobei:
die Halbleitervorrichtungen, der Filterkondensator, der Kühlblock, die Kühlrippe und die Gate-Steuerschaltungen in einer Stromrichtereinheit (6) enthalten sind, die in einem unterhalb eines Bodens des Schienenfahrzeugs angebrachten gemeinsamen Kasten (20) aufgenommen sind;
**dadurch gekennzeichnet, dass**:
der Filterkondensator, die Halbleitervorrichtungen, der Kühlblock, die Kühlrippe und die Gate-Steuerschaltungen aneinander befestigt sind und an dem gemeinsamen Kasten befestigt und durch diesen gelagert sind, so dass die Stromrichtereinheit als einstückige Vorrichtung an dem gemeinsamen Kasten angebracht und von diesem entfernt werden kann;
die Vielzahl von Gate-Steuerschaltungen in einer Aussparung an einer Vorderseite der Stromrichtereinheit und unterhalb des Filterkondensators angeordnet ist;
die Kühlrippe auf der Rückseite der Stromrichtereinheit angeordnet ist;
die Vielzahl von Gate-Steuerschaltungen an einem gemeinsamen Rahmen (9) so befestigt ist, dass die Gate-Steuerschaltungen kollektiv befestigt und entfernt werden können;
eine Verdrahtung zwischen der Vielzahl von Gate-Steuerschaltungen und dem Kühlblock eine Einsteckanordnung umfasst, so dass die Verdrahtung durch das Hineindrücken des gemeinsamen Rahmens in eine Befestigungsposition in Bezug auf den Kühlblock verbunden wird; und
die Vielzahl von Gate-Steuerschaltungen Verbindungsanschlüsse aufweist, um einen Eingang von Signalen von außerhalb an der Vorderseite der Gate-Spannungen zu empfangen.

2. Stromrichter für ein Schienenfahrzeug nach Anspruch 1, der ferner Folgendes umfasst:
einen selbststehenden Rahmen (10), der auf dem unteren Abschnitt der Stromrichtereinheit angeordnet ist, um zu ermöglichen, dass der Stromrichter unabhängig von dem gemeinsamen Kasten stehen kann, bevor er an dem gemeinsamen Kasten befestigt wird.

3. Stromrichter für ein Schienenfahrzeug nach Anspruch 1, wobei
die Vielzahl von Gate-Steuerschaltungen nebeneinander in einer horizontalen Anordnung angeordnet sind.

## Revendications

1. Convertisseur de puissance pour matériel roulant ferroviaire comprenant :
une pluralité de dispositifs à semi-conducteur (1) constituant un circuit de convertisseur de puissance ;
une pluralité de circuits de commande de grille (7) pour fournir des signaux de grille aux dispositifs à semi-conducteur ;
un condensateur de filtrage (2) connecté aux bornes CC du circuit convertisseur de puissance pour lisser un courant CC ;
un bloc de refroidissement (4) fixé aux dispositifs à semi-conducteur ; et
une ailette de refroidissement (5) pour rayonner dans l'atmosphère de la chaleur générée par les dispositifs à semi-conducteur ;
dans lequel :
les dispositifs à semi-conducteur, le condensateur de filtrage, le bloc de refroidissement, l'ailette de refroidissement et les circuits de commande de grille sont compris dans une unité de convertisseur de puissance (6) qui est stockée dans un boîtier commun (20) monté sous un plancher du matériel roulant ferroviaire ;
**caractérisé en ce que** :
le condensateur de filtrage, les dispositifs à semiconducteurs, le bloc de refroidissement, l'ailette de refroidissement et les circuits de commande de grille sont fixés les uns aux autres, puis fixés et supportés par le boîtier commun, de sorte que l'unité de convertisseur de puissance peut être attaché au boîtier commun et détaché de celui-ci en tant que dispositif intégré ;
la pluralité de circuits de commande de grille sont agencés dans un espace situé sur un côté avant de l'unité de convertisseur de puissance et au-dessous du condensateur de filtrage ;
l'ailette de refroidissement est agencée sur le côté arrière de l'unité de convertisseur de puissance ;
la pluralité de circuits de commande de porte sont fixés à un cadre commun (9) de sorte que les circuits de commande de grille peuvent être attachés et détachés de manière collective ;
le câblage entre la pluralité de circuits de commande de grille et le bloc de refroidissement adopte un agencement enfichable, de sorte que le câblage est connecté en poussant le cadre commun dans une position de fixation par rapport au bloc de refroidissement ; et
la pluralité de circuits de commande de grille ont des bornes de connexion pour recevoir une entrée de signaux provenant de l'extérieur au niveau du côté avant des circuits de commande de grille.

2. Convertisseur de puissance pour matériel roulant ferroviaire selon la revendication 1, comprenant en outre :
un cadre autoportant (10) disposé sur la partie inférieure de l'unité de convertisseur de puissance pour permettre au convertisseur de puissance de se tenir indépendamment du boîtier commun avant d'être fixé au boîtier commun.

3. Convertisseur de puissance pour matériel roulant ferroviaire selon la revendication 1, dans lequel
la pluralité de circuits de commande de grille sont agencés côte à côte selon un agencement horizontal.
